# EUROPEAN PATENT APPLICATION

(11) **EP 4 382 503 A1**
(43) Date of publication of application: **12.06.2024**
(21) Application number: 22853103.4
(22) Date of filing: 03.08.2022
(51) Int. Cl.: C04B 35/117, C04B 35/10, H05K 1/03

(54) **CERAMIC SINTERED BODY, CERAMIC SUBSTRATE, MOUNTING SUBSTRATE, ELECTRONIC DEVICE, AND METHOD FOR MANUFACTURING CERAMIC SINTERED BODY**

(30) Priority: 03.08.2021 JP 2021127812; 29.10.2021 JP 2021177914
(71) Applicant: Kyocera Corporation, Kyoto-shi Kyoto 612-8501 (JP)
(72) Inventor: TANI, Yoshito, Kyoto-shi, Kyoto 612-8501 (JP)
(74) Representative: Viering, Jentschura & Partner mbB Patent- und Rechtsanwälte
(86) International application number: PCT/JP2022/029822
(87) International publication number: WO 2023/013684

(57) **Abstract**

A ceramic sintered body includes a ceramic sintered body containing Al₂O₃ (alumina) and an additive, in which a content of Al₂O₃ is 94 mass% or greater. The additive contains SiO₂ (silica), CaO (calcia), MgO (magnesia), TiO₂ (titanium oxide), and Fe₂O₃ (iron oxide). In the ceramic sintered body, a content of Ti (titanium) in terms of TiOz is 120 ppm or greater, and a content of Fe (iron) in terms of Fe₂O₃ is 180 ppm or greater.

## Description

### TECHNICAL FIELD

The disclosed embodiment relates to a ceramic sintered body, a ceramic substrate, a mounting substrate, an electronic device, and a method for manufacturing a ceramic sintered body.

### BACKGROUND OF INVENTION

In the known art, since a ceramic substrate using a ceramic sintered body as a substrate has excellent insulation properties and thermal conductivity, the ceramic substrate may be used as a mounting substrate for mounting an electronic component. For example, Patent Document 1 discloses a ceramic substrate containing Al₂O₃ (alumina) as a main component and TiOz (titanium oxide) as an additive. Cited Document 1 also describes that an Al₂O₃ powder having a particle size from 120 nm to 500 nm is used and that the powder has a particle size of 1 µm or less.

Patent Document 2 describes a mounting substrate in which a copper plate and an alumina substrate in contact with each other are heated in an inert atmosphere to dispose the copper plate on the alumina substrate. The method disclosed in Patent Document 2 is referred to as an active metal bonding (AMB) method. In addition, Patent Document 3 describes a mounting substrate prepared using a direct bonding method of ceramic and copper. The method disclosed in Patent Document 3 is referred to as a direct copper bonding (DCB) method. Cited Document 4 describes a method of manufacturing a circuit board in which a metal plate including copper or a copper alloy is bonded to a surface of a substrate made of alumina or the like using a hot pressing process.

### CITATION LIST

### PATENT LITERATURE

Patent Document 1: JP 2017-218368 A
Patent Document 2: JP S63-166774 A
Patent Document 3: JP H5-243725 A
Patent Document 4: JP 2020-145335 A

### SUMMARY

In an aspect of an embodiment, a ceramic sintered body contains Al₂O₃ (alumina) and an additive, in which a content of Al₂O₃ is 94 mass% or greater. The additive contains SiOz (silica), CaO (calcia), MgO (magnesia), TiOz (titanium oxide), and Fe₂O₃ (iron oxide). In the ceramic sintered body, a content of Ti (titanium) in terms of TiOz is 120 ppm or greater, and a content of Fe (iron) in terms of Fe₂O₃ is 180 ppm or greater.

### BRIEF DESCRIPTION OF THE DRAWINGS

FIG. 1 is a side view illustrating an overview of a mounting substrate according to an embodiment.
FIG. 2 is a TEM photograph of a surface of a ceramic sintered body according to the embodiment.
FIG. 3 is an EDX image showing an analysis result of distribution of a specific element in the same place as the TEM photograph illustrated in FIG. 2.
FIG. 4 is an EDX image showing an analysis result of distribution of a specific element in the same place as the TEM photograph illustrated in FIG. 2.
FIG. 5 is an EDX image showing an analysis result of distribution of a specific element in the same place as the TEM photograph illustrated in FIG. 2.
FIG. 6 is an EDX image showing an analysis result of distribution of a specific element in the same place as the TEM photograph illustrated in FIG. 2.
FIG. 7 is an EDX image showing an analysis result of distribution of a specific element in the same place as the TEM photograph illustrated in FIG. 2.
FIG. 8 is an EDX image showing an analysis result of distribution of a specific element in the same place as the TEM photograph illustrated in FIG. 2.
FIG. 9 is an EDX image showing an analysis result of distribution of a specific element in the same place as the TEM photograph illustrated in FIG. 2.
FIG. 10 is a side view illustrating an example of an electronic device according to the embodiment.
FIG. 11 is a graph illustrating an example of an approximate function showing a relationship between a blended content and an ICP content.

### DESCRIPTION OF EMBODIMENTS

Hereinafter, embodiments of a ceramic sintered body, a ceramic substrate, a mounting substrate, an electronic device, and a method for manufacturing a ceramic sintered body disclosed in the present application will be described with reference to the accompanying drawings. The present disclosure is not limited by the following embodiments. Note that the drawings are schematic and that the dimensional relationships between elements, the proportions of the elements, and the like may differ from the actual ones. There may be differences between the drawings in terms of dimensional relationships, proportions, and the like.

In the embodiments described below, expressions such as "constant", "orthogonal", "perpendicular", and "parallel" may be used, but these expressions do not mean exactly "constant", "orthogonal", "perpendicular", and "parallel". In other words, it is assumed that the above expressions allow deviations in manufacturing accuracy, installation accuracy, or the like.

### Mounting Substrate

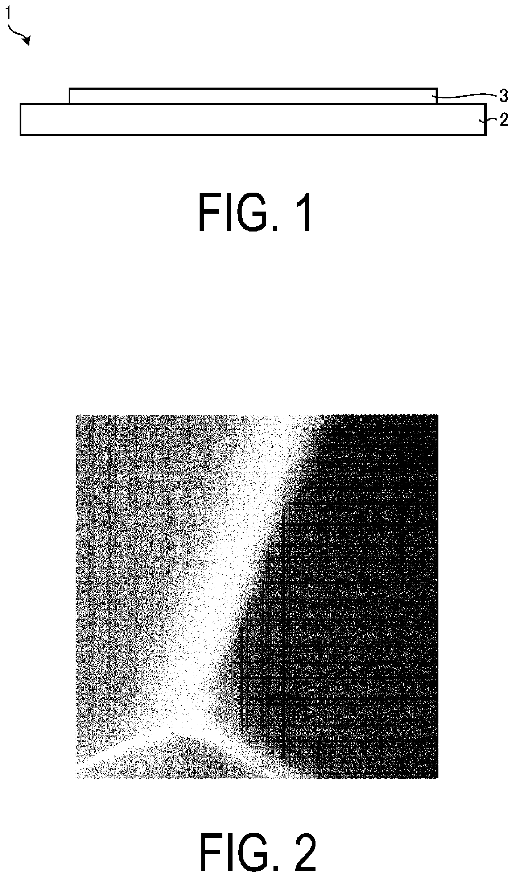

FIG. 1 is a side view illustrating an overview of a mounting substrate 1 according to the embodiment. The mounting substrate 1 illustrated in FIG. 1 includes a ceramic substrate 2 including a ceramic sintered body and a metal layer 3. Since the ceramic sintered body is substantially the same as the ceramic substrate 2, a reference numeral unique to the ceramic sintered body in the drawings is omitted. In other words, the reference numeral of the ceramic sintered body in the drawing is 2. The ceramic sintered body may be used for structural members such as a rod body, a block body, and a hollow member.

The ceramic substrate 2 is a plate-shaped member including a ceramic sintered body containing Al₂O₃ (alumina) and additives and having an Al₂O₃ content of 94 mass% or greater, and having a thickness of, for example, about from 0.2 to 1 mm. The additive contains SiOz (silica), CaO (calcia), MgO (magnesia), TiO₂ (titanium oxide), and Fe₂O₃ (iron oxide).

For the ceramic substrate 2 according to the embodiment, in the ceramic sintered body, a content of Ti (titanium) in terms of TiOz is 120 ppm or greater, and a content of Fe (iron) in terms of Fe₂O₃ is 180 ppm or greater. Thus, when using the ceramic sintered body according to the embodiment, the ceramic substrate 2 has high mechanical strength. According to the embodiment, the ceramic sintered body has excellent thermal shock resistance.

In the ceramic sintered body, the content of Ti in terms of TiOz and the content of Fe in terms of Fe₂O₃ can be determined by, for example, the following method. First, quantitative analysis of Ti and Fe in the ceramic sintered body is performed using an ICP emission spectrophotometer (ICP). Then, the content (ICP content) in terms of TiOz as an oxide is determined from the content of Ti measured by ICP, and the content (ICP content) in terms of Fe₂O₃ as an oxide is determined from the content of Fe measured by ICP.

When using the ceramic sintered body according to the embodiment, the reason why the ceramic substrate 2 can improve the mechanical strength is considered as follows, for example. That is, when TiOz is contained in the ceramic sintered body constituting the ceramic substrate 2, TiOz is located at a crystal grain boundary of the ceramic sintered body. When the content of TiOz in the ceramic sintered body is 120 ppm or greater, TiOz located at the crystal grain boundary of the ceramic sintered body functions as a resistor that suppresses the progress of a crack that is likely to occur at the crystal grain boundary. Since TiOz located at the crystal grain boundary of the ceramic sintered body serves as a crystal nucleus for a sintering aid component (for example, SiOz, CaO, and MgO), it is possible to polycrystallize and toughen the crystal grain boundary, and it is possible to suppress occurrence of a crack. Therefore, when the ceramic sintered body contains TiOz at a suitable content, the mechanical strength of the ceramic substrate 2 can be improved.

When the ceramic sintered body constituting the ceramic substrate 2 contains Fe₂O₃, Fe₂O₃ is located at the crystal grain boundary of the ceramic sintered body. When the content of Fe₂O₃ in the ceramic sintered body is 180 ppm or greater, Fe₂O₃ located at the crystal grain boundary of the ceramic sintered body causes a phenomenon of moving the crystal grain boundary and moving TiOz located at the crystal grain boundary. Therefore, when the ceramic sintered body contains Fe₂O₃ at a suitable content, the crystal grain boundaries and TiOz can be suitably dispersed. The mechanical strength of the ceramic substrate 2 is improved as the crystal grain boundary and the dispersion of TiOz proceed. Therefore, according to the ceramic substrate 2 of the embodiment, the mechanical strength of the ceramic substrate 2 can be improved.

For the ceramic sintered body constituting the ceramic substrate 2 according to the embodiment, the ceramic sintered body may contain 96 mass% or greater and 98 mass% or less of Al₂O₃. When the content of Al₂O₃ is less than 96 mass%, the proportion of sintering aid components (for example, SiOz, CaO, and MgO) in the ceramic sintered body increases, and therefore, sintering between aluminum oxides (Al₂O₃) as the main component may become insufficient. When the content of Al₂O₃ is greater than 98 mass%, the crystal of Al₂O₃ is hardly densified, and therefore, the mechanical strength of the ceramic substrate 2 may be reduced.

In the ceramic sintered body constituting the ceramic substrate 2 according to the embodiment, the content of Ti in terms of TiOz is preferably 350 ppm or less. When the content of TiOz is greater than 350 ppm, the distribution of TiOz located at the crystal grain boundary of the ceramic sintered body is biased, and therefore, the mechanical strength of the ceramic substrate 2 may be reduced.

In the ceramic sintered body constituting the ceramic substrate 2 according to the embodiment, the content of Fe in terms of Fe₂O₃ is preferably greater than the content of Ti in terms of TiOz. When the content of TiOz is greater than the content of Fe, the distribution of TiOz located at the crystal grain boundary of the ceramic sintered body is biased, and therefore, the mechanical strength of the ceramic substrate 2 may be reduced. The content of Fe in terms of Fe₂O₃ in the ceramic sintered body constituting the ceramic substrate 2 is preferably 410 ppm or less.

For the ceramic sintered body constituting the ceramic substrate 2 according to the embodiment, the ceramic sintered body does not contain ZrOz (zirconia). ZrOz (zirconia) is relatively expensive. Thus, since the ceramic sintered body does not contain ZrOz, the raw material cost can be suppressed.

In addition, since ZrOz is not contained in the ceramic substrate 2 according to the embodiment, thermal conductivity can be improved and a dielectric loss can be reduced. For example, in the ceramic substrate containing ZrOz at a ratio of Al₂O₃ : ZrO₂ (including Y₂O₃ (yttria)) = 90 : 10, the thermal conductivity is 23 W/m·K, and the dielectric loss at 1 MHz is 2 × 10⁻⁴. On the other hand, in the ceramic substrate 2 according to the embodiment, for example, the thermal conductivity is 25 W/m·K, and the dielectric loss at 1 MHz is 0.4 × 10⁻⁴. According to the ceramic substrate 2 of the embodiment, effective characteristic values are obtained also from the viewpoint of the thermal conductivity and the dielectric loss.

In the ceramic sintered body constituting the ceramic substrate 2 according to the embodiment, TiOz and Fe₂O₃ are located at the crystal grain boundary. The positions of TiOz and Fe₂O₃ in the ceramic sintered body can be determined by, for example, observing the surface of the ceramic substrate 2 using a scanning electron microscope (SEM) or an energy dispersive X-ray analyzer (EDX) attached to a transmission electron microscope (TEM).

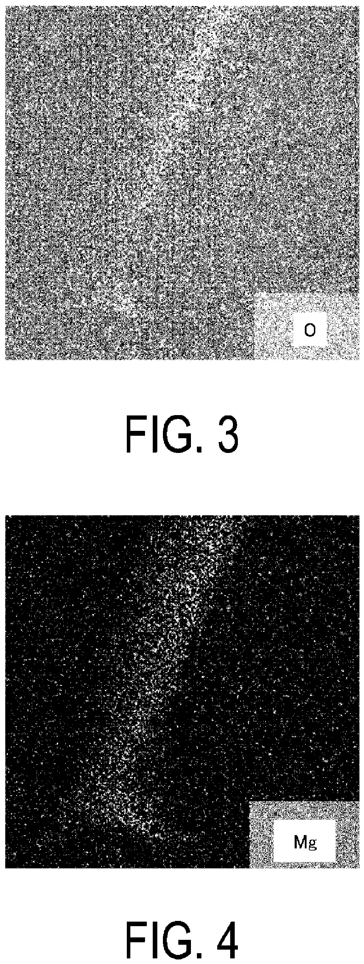

FIG. 2 is a TEM photograph of the surface of the ceramic substrate 2 according to the embodiment. FIGs. 3 to 9 are each an EDX image showing an analysis result of distribution of a specific element in the same place as the TEM photograph illustrated in FIG. 2.

The observation by TEM and EDX was performed at a magnification of 500000 times. In the TEM photograph of FIG. 2, the crystal grain boundary of the ceramic sintered body is indicated by a white region.

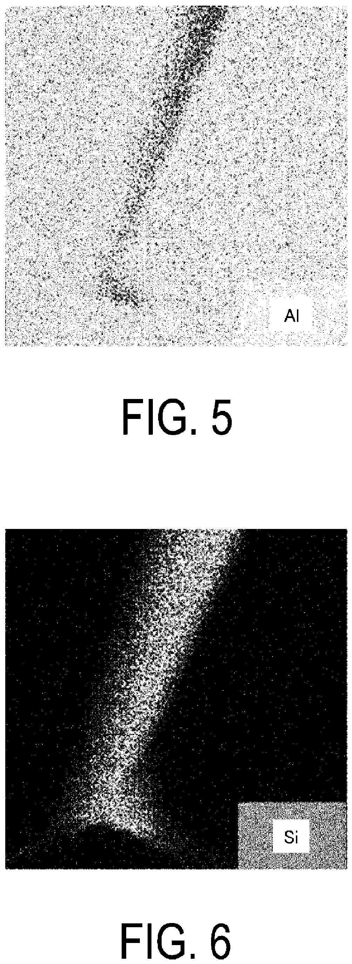

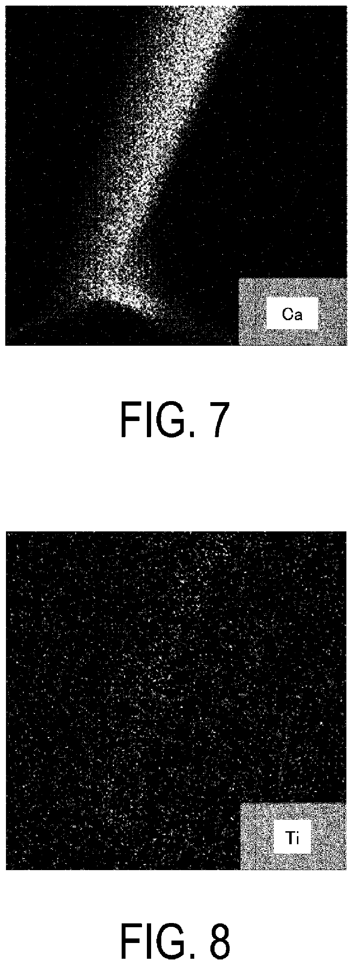

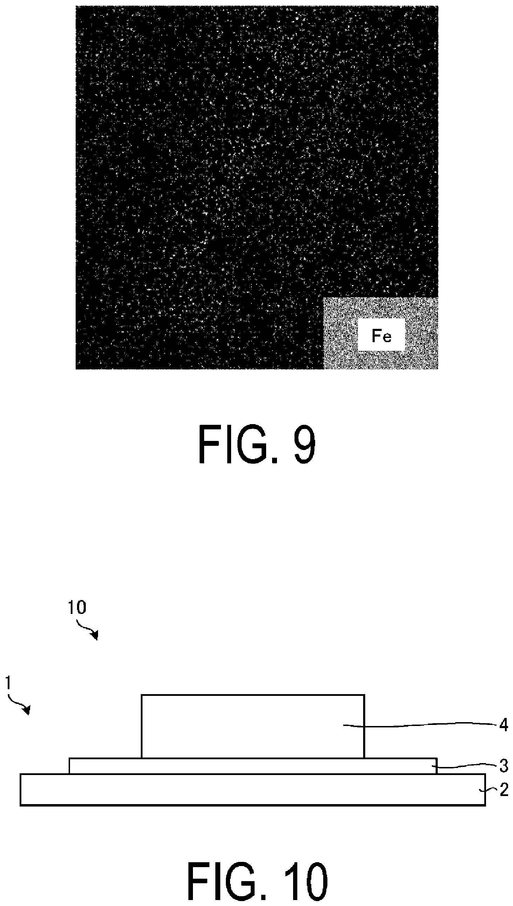

The EDX image of FIG. 3 is a composite image showing the analysis result of the distribution of O (oxygen). The EDX image of FIG. 4 is a composite image showing the analysis result of the distribution of Mg (magnesium). The EDX image of FIG. 5 is a composite image showing the analysis result of the distribution of Al (aluminum). The EDX image of FIG. 6 is a composite image showing the analysis result of the distribution of Si (silicon). The EDX image of FIG. 7 is a composite image showing the analysis result of the distribution of Ca (calcium). The EDX image of FIG. 8 is a composite image showing the analysis result of the distribution of Ti (titanium). The EDX image of FIG. 9 is a composite image showing the analysis result of the distribution of Fe (iron). In the EDX images illustrated in FIGs. 4 to 9, a region having a large amount of a specific element (that is, O, Mg, Al, Si, Ca, Ti, or Fe) is shown in white.

From the TEM photograph of FIG. 2 and the EDX images of FIGs. 4 to 9, it can be seen that, in the ceramic sintered body constituting the ceramic substrate 2, TiOz and Fe₂O₃ are located at the crystal grain boundary of the ceramic sintered body similarly to the sintering aid components (for example, SiOz, CaO, and MgO).

When TiOz and Fe₂O₃ are located at the crystal grain boundary of the ceramic sintered body as described above, the occurrence and progress of cracks at the crystal grain boundary can be suppressed. Therefore, according to the ceramic substrate 2 of the embodiment, the mechanical strength can be further improved.

FIG. 1 will be described again. The metal layer 3 is located on the ceramic substrate 2. The metal layer 3 is, for example, a metal plate. The thickness of the metal plate can be, for example, about from 0.1 to 5 mm. As a material of the metal plate, for example, copper or aluminum can be used. The metal plate can be bonded onto the ceramic substrate using, for example, an AMB (Active Metal Bonding) method disclosed in Patent Document 2, a DCB (Direct Copper Bonding) method disclosed in Patent Document 3, a method using hot pressing disclosed in Patent Document 4, or the like. The bonding conditions of the ceramic substrate 2 and the metal plate 3 are not limited to the conditions in the ranges disclosed in Patent Documents 2 to 4. The metal layer 3 may be, for example, a metal paste containing a noble metal such as copper, silver, or platinum as a main component. In this case, the thickness of the metal paste can be, for example, about from 1 to 40 µm. The metal layer 3 may contain Ti and Fe at least on a side of the metal layer 3 adjacent to the ceramic substrate 2. Since the ceramic substrate 2 contains Fe and Ti, Ti and Fe diffuse from the ceramic substrate 2 to the metal layer 3 at the time of bonding, thereby increasing the bonding strength between the ceramic substrate 2 and the metal layer 3. An alloy or a compound containing Ti, Fe, and Cu may be located in the metal layer 3. The metal layer 3 may be located on both surfaces of the ceramic substrate 2. Furthermore, the metal plate 3 may be located on one surface of the ceramic substrate 2, and a heat dissipation member may be located on the other surface.

### Electronic Device

Next, a configuration of an electronic device 10 including the above-described mounting substrate 1 will be described with reference to FIG. 10. FIG. 10 is a side view illustrating an example of the electronic device 10 according to the embodiment.

As illustrated in FIG. 10, the electronic device 10 includes the mounting substrate 1 and an electronic component 4 located on the metal layer 3 of the mounting substrate 1. A heat sink or a channel member for dissipating heat from the electronic component 4 may be located on a surface of the mounting substrate 1 opposite to a surface on which the metal layer 3 is located.

As the electronic component 4, for example, a semiconductor element such as a light emitting diode (LED) element, an insulated gate bipolar transistor (IGBT) element, an intelligent power module (IPM) element, a metal oxide film field-effect transistor (MOSFET) element, a freewheeling diode (FWD) element, a giant transistor (GTR) element, or a Schottky barrier diode (SBD), or a heating element such as a sublimation type thermal printer head element, a thermal inkjet printer head element, or a Peltier element can be used.

### Manufacturing Method

Next, a method of manufacturing the ceramic substrate 2 will be described, which is included in the mounting substrate 1 according to the embodiment.

An Al₂O₃ (aluminum) powder is prepared as a main raw material. As additives, powders of SiO₂ (silica), CaO (calcia), MgO (magnesia), TiO₂ (titanium oxide), and Fe₂O₃ (iron oxide) are prepared.

First, a powder of Al₂O₃ and a powder of an additive are blended such that the content of Al₂O₃ is 94 mass% or greater to produce a blended powder. A blending composition at this time is as follows. Al contained in the ceramic substrate 2 is 94 mass% or greater in terms of Al₂O₃. The sum of values obtained by converting Si into SiOz, Ca into CaO, Mg into MgO, Ti into TiO₂, and Fe into Fe₂O₃ (i.e., the additive contained in the ceramic substrate 2) is 1.0 mass% or greater and 6.0 mass% or less. A mass ratio of SiOz in the additive is, for example, 38 mass% or greater and 60 mass% or less. A mass ratio of CaO in the additive is, for example, 20 mass% or greater and 43 mass% or less. A mass ratio of MgO in the additive is, for example, 14 mass% or greater and 37 mass% or less. A content of Fe contained as an impurity in the powder of Al₂O₃ in terms of Fe₂O₃ is from 100 to 300 ppm.

It is preferable that, in the additive, a content (blended content) of Ti in terms of TiOz be 0.48 mass% or greater and 1.18 mass% or less, and a content (blended content) of Fe in terms of Fe₂O₃ be 0.48 mass% or greater.

Next, a solvent and a binder are added to a blended powder produced by blending the powder of Al₂O₃ and the powder of the additive, and then they are mixed and pulverized by, for example, a ball mill or the like to prepare a slurry.

Next, the slurry is spray-dried using a spray dryer to produce granules.

Thereafter, the granules are molded by a press molding method, a roll compaction molding method, or the like to prepare a molded body having a desired shape. Instead of preparing granules, a slurry may be molded by a doctor blade method to prepare a sheet-shaped molded body. In addition, a cut-out, a hole, a recess, or the like may be formed in the prepared molded body by a drill, a laser, or the like as necessary.

Next, the molded body is subjected to heat treatment to perform degreasing, and then the molded body is fired. The firing temperature is, for example, in a range of 1500°C or higher and 1600°C or lower. The composition after firing is the same as the blended composition except for TiO₂ and Fe₂O₃. The ceramic sintered body produced by firing the molded body may be subjected to polishing, grinding, drilling, laser processing, blasting, or the like as necessary. As described above, the ceramic substrate 2 is produced using the ceramic sintered body according to the embodiment.

### EXAMPLES

Hereinafter, examples of the ceramic substrate 2 according to the embodiment will be specifically described.

### Example 1

A ceramic sintered body (Samples Nos. 3 to 8) of Example 1 was prepared as follows. A powder of Al₂O₃ and a powder of the additive were blended such that the contents (mass%) of Al₂O₃ and the additive contained in the ceramic sintered body were the contents shown in Table 1 to prepare a blended powder. Next, after a solvent and a binder were added to the blended powder, granules were prepared through a slurry, and the granules were reshaped as desired by press molding to prepare a molded body. Thereafter, the binder component was removed by degreasing, and then the molded body was fired to produce a ceramic sintered body (Samples Nos. 3 to 8).

### ICP Content

Next, the content of the metal element (Ti, Fe) in the produced ceramic sintered body was measured by ICP, and the content (ICP content) in terms of oxide (TiO₂, Fe₂O₃) was determined. The resulting value of each ICP content is shown in Table 1.

In the ICP contents shown in Table 1, the underlined numerical values of the ICP contents are values estimated using an approximate function indicating a relationship between a blended content (that is, in the additive, a content of Ti in terms of TiO₂ and a content of Fe in terms of Fe₂O₃) and an ICP content.

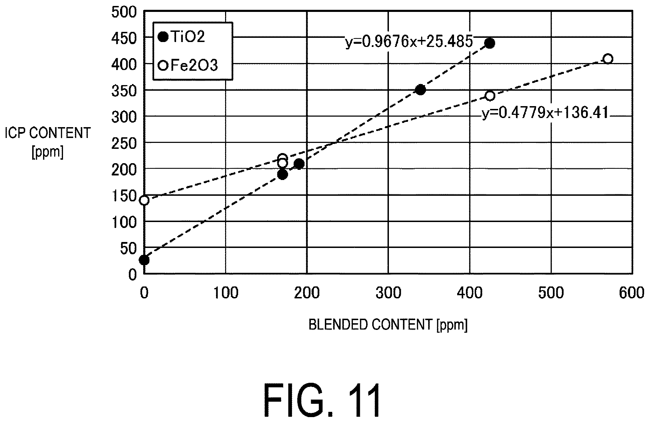

FIG. 11 is a graph illustrating an example of an approximate function showing a relationship between a blended content and an ICP content. FIG. 11 shows an approximate function indicating the relationship between the blended content and the ICP content for TiOz and an approximate function indicating the relationship between the blended content and the ICP content for Fe₂O₃. Each approximate function is generated based on each measured value of the ICP content with respect to the blended content. In the ICP contents shown in Table 1, the numerical value of the underlined ICP content can be estimated by applying each blended content to each approximate function shown in FIG. 11. In Table 1, the underlined numerical value (that is, the estimated value) of the ICP content is a numerical value obtained by rounding off the decimal point.

Three-Point Bending Strength Test and Thermal Shock Resistance Test Samples of the produced ceramic sintered bodies were each processed into a test piece of 3 mm × 4 mm × 40 mm (hereinafter also referred to as "JIS piece"). The JIS piece was prepared by a press molding method. Using this JIS piece, a three-point bending strength test and a thermal shock resistance test were performed. The results of the thermal shock resistance test will be described below.

The three-point bending strength of each sample was measured in accordance with JIS R 1601-2008. A crosshead speed used for measuring the three-point bending strength was 0.5 mm/min. The obtained results of the three-point bending strength test are as shown in Table 1. The thermal shock resistance test was performed in accordance with JIS R 1648-2002. The crosshead speed in the thermal shock resistance test was also 0.5 mm/min.

### Comparative Example 1

A ceramic sintered body of Comparative Example 1 (Sample No. 1) was prepared under the same conditions as in Example 1 except that the powder of TiOz was not blended as an additive to the powder of Al₂O₃.

The ICP content for a metal element (Ti, Fe) in the produced ceramic sintered body was measured and estimated in the same manner as described above. The resulting value of each ICP content is shown in Table 1. In Table 1, the ICP content of TiOz in the ceramic sintered body is not 0. This is because the powder of Al₂O₃ to be blended contains TiOz as an impurity.

The produced ceramic sintered body was subjected to the same three-point bending strength test as in Example 1. The result of the three-point bending strength test is as shown in Table 1.

### Comparative Example 2

A ceramic sintered body of Comparative Example 2 (Sample No. 2) was prepared under the same conditions as in Example 1 except that the powder of Fe₂O₃ was not blended as an additive to the powder of Al₂O₃.

The ICP content for a metal element (Ti, Fe) in the produced ceramic sintered body was measured and estimated in the same manner as in Example 1. The resulting value of each ICP content is shown in Table 1. In Table 1, the ICP content of Fe₂O₃ in the ceramic sintered body is not 0. This is because the Al₂O₃ powder to be blended contains Fe₂O₃ as an impurity.

The produced ceramic sintered body was subjected to the same three-point bending strength test as in Example 1. The result of the three-point bending strength test is as shown in Table 1.

### [Table 1]

**Table 1**

| Sample No. | Al₂O₃ (mass%) | Additive (mass%) | ICP content (in sintered body, in terms of oxide) | | Three-point bending strength (MPa) | Sample shape |
|---|---|---|---|---|---|---|
| | | | TiO2 (ppm) | Fe2O3 (ppm) | | |
| 1 | 96 | 4 | 26 | 210 | 397 | JIS piece |
| 2 | 96 | 4 | 350 | 140 | 462 | JIS piece |
| 3 | 96 | 4 | 190 | 220 | 493 | JIS piece |
| 4 | 96 | 4 | 270 | 260 | 530 | JIS piece |
| 5 | 96 | 4 | 350 | 300 | 563 | JIS piece |
| 6 | 96 | 4 | 440 | 340 | 522 | JIS piece |
| 7 | 94 | 6 | 580 | 410 | 516 | JIS piece |
| 8 | 99 | 1 | 120 | 180 | 547 | JIS piece |

In Samples Nos. 1 and 2 in which the powder of TiOz or the powder of Fe₂O₃ was not added as an additive to the powder of Al₂O₃, the three-point bending strength was less than 490 MPa. On the other hand, in Samples Nos. 3 to 8, which are the ceramic sintered bodies of Example 1, the three-point bending strength was 490 MPa or greater.

From the above results, it is preferable that, in the ceramic sintered body, the content of Ti (titanium) in terms of TiOz be 120 ppm or greater, and the content of Fe (iron) in terms of Fe₂O₃ be 180 ppm or greater.

### Example 2

A ceramic sintered body (Samples Nos. 9 to 12) was prepared by changing the contents (mass%) of Al₂O₃ and the additive. The conditions were the same as in Example 1 except that the contents (mass%) of Al₂O₃ and the additive contained in the ceramic sintered body were changed to the contents shown in Table 2. Samples Nos. 9, 10, and 12 are the same as Samples Nos. 7, 5, and 8, respectively.

The same measurement and estimation of the ICP content as in Example 1 and the same three-point bending strength test as in Example 1 were performed. The resulting value of each ICP content is shown in Table 2. The obtained results of the three-point bending strength test are as shown in Table 2.

### [Table 2]

**Table 2**

| Sample No. | Al2O3 (mass%) | Additive (mass%) | ICP content (in sintered body, in terms of oxide) | | Three-point bending strength (MPa) | Sample shape |
|---|---|---|---|---|---|---|
| | | | TiO2 (ppm) | Fe2O3 (ppm) | | |
| 9 | 94 | 6 | 580 | 410 | 516 | JIS piece |
| 10 | 96 | 4 | 350 | 300 | 563 | JIS piece |
| 11 | 98 | 2 | 210 | 230 | 594 | JIS piece |
| 12 | 99 | 1 | 120 | 180 | 547 | JIS piece |

Samples Nos. 10 and 11 in which the content of Al₂O₃ was 96 mass% or greater and 98 mass% or less had higher three-point bending strength than Sample No. 9 in which the content of Al₂O₃ was less than 96 mass% and Sample No. 12 in which the content of Al₂O₃ was greater than 98 mass%.

From the above results, for the ceramic sintered body constituting the ceramic substrate 2 according to the embodiment, the ceramic sintered body preferably contains 96 mass% or greater and 98 mass% or less of Al₂O₃.

Samples Nos. 10 to 12 in which the ICP content of TiOz was 350 ppm or less had higher three-point bending strength than Sample No. 9 in which the ICP content of TiOz was greater than 350 ppm.

From the above results, in the ceramic sintered body constituting the ceramic substrate 2 according to the embodiment, the content of Ti in terms of TiOz is preferably 350 ppm or less.

### Example 3

A ceramic sintered body (Samples Nos. 13 and 14) was prepared by changing the content of Fe in terms of Fe₂O₃ and the content of Ti in terms of TiOz in the ceramic sintered body. The conditions were the same as in Example 1 except that the content of Fe in terms of Fe₂O₃ and the content of Ti in terms of TiOz in the ceramic sintered body were changed to the ICP contents shown in Table 3, and the contents (mass%) of Al₂O₃ and the additive contained in the ceramic sintered body were changed to the contents shown in Table 3.

The ICP content was measured and estimated in the same manner as in Example 1. The resulting value of each ICP content is shown in Table 3.

### Three-Point Bending Strength Test

Samples of the produced ceramic sintered bodies were each processed into a test piece of 24 mm × 40 mm × 0.32 mm (hereinafter referred to as "test substrate"). The test substrate was prepared by a roll compaction molding method.

The three-point bending strength of each sample was measured in accordance with JIS R 1601-2008. A crosshead speed used for measuring the three-point bending strength was 5 mm/min. The obtained results of the three-point bending strength test are as shown in Table 3.

### [Table 3]

**Table 3**

| Sample No. | Al2O3 (mass%) | Additive (mass%) | ICP content (in sintered body, in terms of oxide) | | Three-point bending strength (MPa) | Sample shape |
|---|---|---|---|---|---|---|
| | | | TiO2 (ppm) | Fe2O3 (ppm) | | |
| | | | | | | |
| 13 | 98 | 2 | 210 | 230 | 630 | Substrate |
| 14 | 98 | 2 | 210 | 410 | 650 | Substrate |

Sample No. 14 in which the ICP content of Fe₂O₃ was greater than the ICP content of TiOz by 200 ppm or greater had higher three-point bending strength than Sample No. 13 in which the difference between the ICP content of Fe₂O₃ and the ICP content of TiOz was 20 ppm or less.

From the above results, in the ceramic sintered body constituting the ceramic substrate 2 according to the embodiment, the content of Fe in terms of Fe₂O₃ is preferably greater than the content of Ti in terms of TiOz.

### Example 4

A ceramic sintered body (Samples Nos. 18 to 20, 22, and 23) of Example 4 was prepared as follows. A powder of Al₂O₃ and a powder of the additive were blended such that the contents (mass%) of Al₂O₃ and the additive contained in the ceramic sintered body were the contents shown in Table 4 to prepare a blended powder. Here, the content of Ti in terms of TiOz and the content of Fe in terms of Fe₂O₃ in the additive were the blended contents shown in Table 4. Next, after a solvent and a binder were added to the blended powder, granules were prepared through a slurry, and the granules were reshaped as desired by press molding to prepare a molded body. Thereafter, the binder component was removed by degreasing, and then the molded body was fired to produce ceramic sintered bodies (Samples Nos. 18 to 20, 22, and 23). Samples Nos. 18 to 20, 22, and 23 are the same as Samples Nos. 3, 5, 6, 7, and 11, respectively.

Each of the produced samples was subjected to the same three-point bending strength test as in Example 1. The results of the three-point bending strength test are as shown in Table 4.

### Comparative Example 3

A ceramic sintered body of Comparative Example 3 (Sample No. 16) was prepared under the same conditions as in Example 4 except that the powder of TiO2 was not blended as an additive to the powder of Al₂O₃. Sample No. 16 is the same sample as Sample No. 1.

The produced ceramic sintered body was subjected to the same three-point bending strength test as in Example 4. The result of the three-point bending strength test is as shown in Table 4.

### Comparative Example 4

A ceramic sintered body of Comparative Example 4 (Sample No. 17) was prepared under the same conditions as in Example 4 except that the powder of Fe₂O₃ was not blended as an additive to the powder of Al₂O₃. Sample No. 17 is the same sample as Sample No. 2.

The produced ceramic sintered body was subjected to the same three-point bending strength test as in Example 4. The result of the three-point bending strength test is as shown in Table 4.

### Comparative Example 5

A ceramic sintered body of Comparative Example 5 (Sample No. 21) was produced under the same conditions as in Example 4 except that the content of Ti in the additive in terms of TiOz was changed to the blended content shown in Table 4.

The produced ceramic sintered body was subjected to the same three-point bending strength test as in Example 4. The result of the three-point bending strength test is as shown in Table 4.

### [Table 4]

**Table 4**

| Sample No. | Al2O3 (mass%) | Additive (mass%) | Blended content (blending ratio in additive material) | | Three-point bending strength (MPa) | Sample shape |
|---|---|---|---|---|---|---|
| | | | TiO2 (mass%) | Fe2O3 (mass%) | | |
| 16 | 96 | 4 | 0 | 0.48 | 397 | JIS piece |
| 17 | 96 | 4 | 0.96 | 0 | 462 | JIS piece |
| 18 | 96 | 4 | 0.48 | 0.48 | 493 | JIS piece |
| 19 | 96 | 4 | 0.95 | 0.95 | 563 | JIS piece |
| 20 | 96 | 4 | 1.18 | 1.18 | 522 | JIS piece |
| 21 | 96 | 4 | 1.41 | 1.41 | 330 | JIS piece |
| 22 | 94 | 6 | 0.95 | 0.95 | 516 | JIS piece |
| 23 | 98 | 2 | 0.95 | 0.95 | 594 | JIS piece |

Sample Nos. 16 and 17 in which the powder of TiOz or the powder of Fe₂O₃ was not added as an additive to the powder of Al₂O₃ and Sample No. 21 in which the blended content of TiOz was greater than 1.18 mass% had three-point bending strength less than 490 MPa. On the other hand, Samples Nos. 18 to 20, 22, and 23, which are the ceramic sintered bodies of Example 4, had a three-point bending strength of 490 MPa or greater.

From the above results, when the blended powder was prepared, it is preferable that, in the additive, the content of Ti in terms of TiOz be 0.48 mass% or greater and 1.18 mass% or less, and the content of Fe in terms of Fe₂O₃ be 0.48 mass% or greater.

The thermal shock resistance test was performed using Samples Nos. 1, 2, and 8 in Example 1. The results of the thermal shock resistance test are as shown in Table 5. Samples Nos. 1 and 2 are comparative examples, and Sample No. 8 is an example. Table 5 also shows the results of evaluating the three-point bending strength of the JIS piece without performing the thermal shock resistance test. The three-point bending strength of the JIS piece that was not subjected to the thermal shock resistance test is provided without a description of temperature. Table 5 shows the three-point bending strength of the JIS piece measured by heating the JIS piece to 190°C, 240 °C, 265°C, and 290°C, then dropping the JIS piece into water having a water temperature of 10°C to rapidly cool the JIS piece, and then performing a three-point bending test.

### [Table 5]

**Table 5**

| Sample No. | Three-point bending strength (MPa) | | | | |
|---|---|---|---|---|---|
| | N/A | 190°C | 240°C | 265°C | 290°C |
| 1 | 397 | 387 | 361 | 270 | 75 |
| 2 | 462 | 445 | 441 | 315 | 100 |
| 8 | 547 | 530 | 523 | 523 | 211 |

In Samples Nos. 1 and 2 as Comparative Examples, the three-point bending strength was deteriorated by about 30% at 265°C, and the three-point bending strength was deteriorated by about 80% at 290°C. On the other hand, in Sample No. 8 as an Example, strength degradation at 265°C was only about 4%, and the three-point bending strength was deteriorated by about 61% at 290°C. From the above, also from the viewpoint of the thermal shock resistance, it is preferable that, in the ceramic sintered body, the content of Ti (titanium) in terms of TiOz is 120 ppm or greater, and the content of Fe (iron) in terms of Fe₂O₃ is 180 ppm or greater.

Further effects and variations can be readily derived by those skilled in the art. Thus, a wide variety of aspects of the present invention are not limited to the specific details and representative embodiments represented and described above. Accordingly, various changes are possible without departing from the spirit or scope of the general inventive concepts defined by the appended claims and their equivalents.

### REFERENCE SIGNS

1 Mounting substrate
2 Ceramic substrate
3 Metal layer
4 Electronic component
10 Electronic device

## Claims

1. A ceramic sintered body comprising:
Al₂O₃; and
an additive,
wherein
a content of the Al₂O₃ is 94 mass% or greater,
the additive contains SiOz, CaO, MgO, TiOz, and Fe₂O₃, and
in the ceramic sintered body,
a content of Ti in terms of TiOz is 120 ppm or greater, and
a content of Fe in terms of Fe₂O₃ is 180 ppm or greater.

2. The ceramic sintered body according to claim 1, wherein the ceramic sintered body contains 96 mass% or greater and 98 mass% or less of the Al₂O₃.

3. The ceramic sintered body according to claim 1 or 2, wherein, in the ceramic sintered body, a content of Ti in terms of TiOz is 350 ppm or less.

4. The ceramic sintered body according to any one of claims 1 to 3, wherein, in the ceramic sintered body, a content of Fe in terms of Fe₂O₃ is greater than a content of Ti in terms of TiO₂.

5. The ceramic sintered body according to any one of claims 1 to 4, wherein, in the ceramic sintered body, a content of Fe in terms of Fe₂O₃ is 410 ppm or less.

6. The ceramic sintered body according to any one of claims 1 to 5, wherein the ceramic sintered body does not contain ZrOz.

7. The ceramic sintered body according to any one of claims 1 to 6, wherein TiOz and Fe₂O₃ in the ceramic sintered body are located at a crystal grain boundary.

8. A ceramic substrate comprising the ceramic sintered body described in any one of claims 1 to 7, the ceramic sintered body being in a plate shape.

9. A mounting substrate comprising:
a ceramic substrate described in claim 8; and
a metal layer located on the ceramic substrate.

10. The mounting substrate according to claim 9, wherein the metal layer contains Ti and Fe at least on a side of the metal layer adjacent to the ceramic substrate.

11. An electronic device comprising:
the mounting substrate described in claim 9 or 10; and
an electronic component located on the metal layer of the mounting substrate.

12. A method for manufacturing a ceramic sintered body comprising:
preparing a blended powder by blending a powder of Al₂O₃ and a powder of an additive such that a content of Al₂O₃ is 94 mass% or greater;
preparing a molded body using the blended powder; and
firing the molded body,
wherein
in the preparing of the blended powder, powders of SiOz, CaO, MgO, TiOz, and Fe₂O₃ as the additives are blended with the powder of Al₂O₃ to prepare the blended powder, and
in the additive,
a content of Ti in terms of TiOz is 0.48 mass% or greater and 1.18 mass% or less, and
a content of Fe in terms of Fe₂O₃ is 0.48 mass% or greater.

13. The method for manufacturing a ceramic sintered body according to claim 12, wherein a content of Fe contained as an impurity in the powder of Al₂O₃ in terms of Fe₂O₃ is from 100 to 300 ppm.
